Europäisches Patentamt

European Patent Office

Office européen des brevets

(11) Veröffentlichungsnummer: **0 318 658 B1**

# EUROPÄISCHE PATENTSCHRIFT

(12)

(45) Veröffentlichungstag der Patentschrift:
27.02.91 Patentblatt 91/09

(51) Int. Cl.⁵: **G01D 5/26**

(21) Anmeldenummer: **88115766.3**

(22) Anmeldetag: **24.09.88**

(54) Verfahren zur Fehlererkennung bei Positionsmesssystemen.

(30) Priorität: **28.11.87 DE 3740445**

(43) Veröffentlichungstag der Anmeldung:
**07.06.89 Patentblatt 89/23**

(45) Bekanntmachung des Hinweises auf die
Patenterteilung:
**27.02.91 Patentblatt 91/09**

(84) Benannte Vertragsstaaten:
**AT CH DE ES FR GB IT LI NL SE**

(56) Entgegenhaltungen:
**DE-A- 2 020 393**
**DE-A- 2 034 397**

(73) Patentinhaber: **DR. JOHANNES HEIDENHAIN
GMBH**
**Dr.-Johannes-Heidenhain-Strasse 5 Postfach
1260**
**D-8225 Traunreut (DE)**

(72) Erfinder: **Schmitt, Walter, Ing.-grad**
**Hochgernstrasse 22**
**D-8225 Traunreut (DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein Verfahren zur Fehlererkennung bei Positionsmeßsystemen gemäß dem Oberbegriff des Anspruchs 1 und eine Vorrichtung nach dem Oberbegriff des Anspruches 2.

Derartige Positionsmeßsysteme werden insbesondere bei Bearbeitungsmaschinen zur Messung der Relativlage eines Werkzeuges bezüglich eines zu bearbeitenden Werkstücks sowie bei Koordinatenmeßmaschinen zur Ermittlung von Lage und/oder Abmessungen von Prüfobjekten eingesetzt.

Aus der DE-OS 20 20 393 ist ein inkrementales Positionsmeßsystem zur Messung der Relativlage zweier Objekte bekannt, bei dem die Teilung eines Teilungsträgers von einer Abtasteinrichtung zur Erzeugung zweier Abtastsignale abgetastet wird, die einmal einer Auswerteeinrichtung und zum anderen einer Fehlererkennungseinrichtung zugeführt werden, die bei fehlerhaften Amplitudenhöhen der beiden Abtastsignale ein Fehlersignal erzeugt. In der Fehlererkennungseinrichtung werden das erste Abtastsignal einer ersten Triggerstufe und das zweite Abtastsignal einer zweiten Triggerstufe zugeleitet. Die erste Triggerstufe enthält einen ersten Trigger mit einer oberen Triggerschwelle und einen zweiten Trigger mit einer unteren Triggerschwelle, die gleichzeitig vom ersten Abtastsignal beaufschlagt werden ; den beiden Triggern der ersten Triggerstufe ist ein erstes Antivalenzgatter nachgeschaltet. Die zweite Triggerstufe enthält einen ersten Trigger mit derselben oberen Triggerschwelle und einen zweiten Trigger mit derselben unteren Triggerschwelle, die gleichzeitig vom zweiten Abtastsignal beaufschlagt werden ; den beiden Triggern der zweiten Triggerstufe ist ein zweites Antivalenzgatter nachgeschaltet. Die beiden Antivalenzgatter sind in der Fehlererkennungseinrichtung über ein Undgatter mit einer Warnlampe verbunden. Zur Überprüfung der Amplitudenhöhen der beiden Abtastsignale gibt die Fehlererkennungseinrichtung ein Fehlererkennungssignal ab, wenn die Amplitudenhöhen des ersten und/oder des zweiten Abtastsignals betragsmäßig unterhalb der oberen und/oder der unteren Triggerschwelle der beiden Triggerstufen absinken, was beispielsweise durch partielle Verschmutzungen oder Beschädigungen der Teilung des Teilungsträgers eintreten kann.

Mit zunehmender Abtastgeschwindigkeit (Abtastfrequenz) der Abtasteinrichtung bezüglich der Teilung des Teilungsträgers tritt jedoch eine Abnahme der Amplitudenhöhen der beiden Abtastsignale ein, so daß bei hohen Abtastfrequenzen die Amplitudenhöhen der beiden Abtastsignale unterhalb der fest eingestellten Triggerschwellen der beiden Triggerstufen absinken können ; in diesen Fällen gibt die Fehlererkennungseinrichtung ein Fehlererkennungssignal ab, ohne daß eine eigentliche Störung (z.B. Verschmutzung oder Beschädigung der Teilung) vorliegt.

Der Erfindung liegt die Aufgabe zugrunde, bei einem Positionsmeßsystem, dessen Abtastsignale einen frequenzabhängigen Amplitudengang aufweisen, frequenzgangbedingte Fehlermeldungen auszuschließen.

Diese Aufgabe wird erfindungsgemäß durch die Merkmale den Ansprüche 1 bis 3 gelöst.

Die mit der Erfindung erzielten Vorteile bestehen insbesondere darin, daß durch die Anpassung der Triggerschwellenspannungen der Triggerstufen sowie der Schwellenspannung der Addierstufe an den frequenzabhängigen Amplitudengang der Abtastsignale nur bei tatsächlich vorliegenden Störungen eine Fehlermeldung erfolgt, so daß bei Bearbeitungsmaschinen, an denen derartige Positionsmeßsysteme zum Einsatz gelangen, durch frequenzgangbedingte Fehlermeldungen hervorgerufene Fehlzeiten entfallen. Diese erfindungsgemäße Maßnahme erfordert nur wenige preiswerte Bauelemente und ermöglicht zudem noch günstigere Amplitudentoleranzbereiche für die Abtastsignale.

Vorteilhafte Ausbildungen der Erfindung entnimmt man den abhängigen Ansprüchen.

Ausführungsbeispiele der Erfindung werden anhand der Zeichnung näher erläutert.

Es zeigen

Figur 1 ein Positionsmeßsystem mit einer Auswerteeinrichtung und einer Fehlererkennungseinrichtung,

Figur 2 ein Diagramm von Abtastsignalen mit fehlerhaften Amplitudenhöhen,

Figur 3 ein Diagramm eines Abtastsignals mit frequenzabhängigem Amplitudengang und

Figur 4 eine weitere Fehlererkennungseinrichtung.

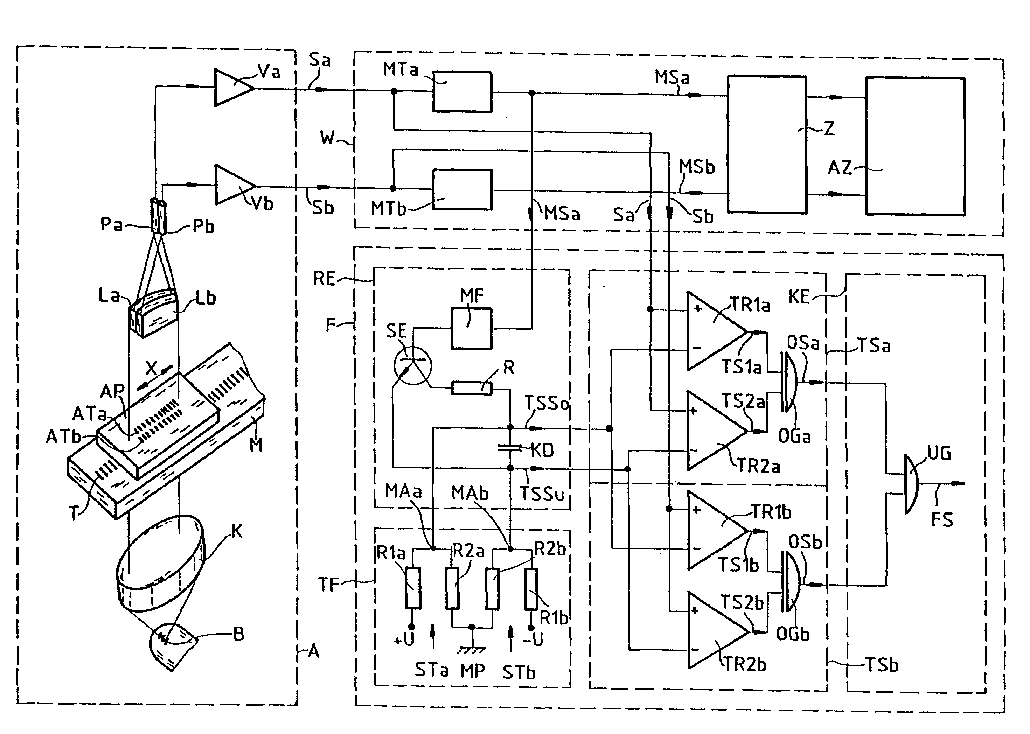

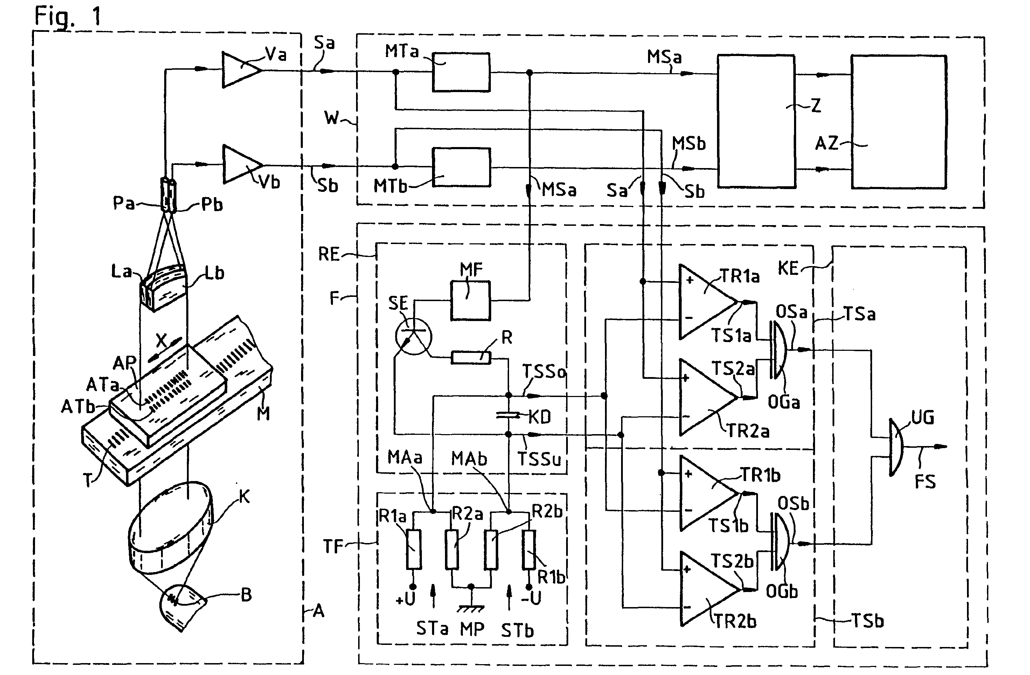

In Figur 1 ist schematisch ein lichtelektrisches inkrementales Längenmeßsystem zur Messung der Relativlage zweier nicht dargestellter Objekte, beispielsweise zweier Maschinenteile einer Bearbeitungsmaschine, gezeigt, bei dem ein Teilungsträger M mit einer inkrementalen Teilung T von einer Abtasteinrichtung A abgetastet wird, die jeweils mit einem der beiden Objekte verbunden sind. Die Abtasteinrichtung A enthält eine Lichtquelle B, einen Kondensor K, eine Abtastplatte AP mit zwei Abtastteilungen ATa, ATb, zwei Linsen La, Lb, zwei Photoelemente Pa, Pb sowie zwei Verstärker Va, Vb ; die beiden Abtastteilungen ATa, ATb der Abtastplatte AP sind mit der Teilung T des Teilungsträgers M identisch und um ein Viertel ihrer Teilungsperiode in Meßrichtung X gegeneinander versetzt. Der Lichtstrom der Lichtquelle B durchsetzt über den Kondensor K die Teilung T des Teilungsträgers M und die beiden Abtastteilungen ATa, ATb der Abtastplatte AP und wird mittels der beiden Linsen La, Lb auf die beiden Photoelemente Pa, Pb abgebildet, die jeweils einer der beiden Abtastteilungen ATa, ATb der Abtastplatte AP zugeordnet sind. Bei der Meßbewegung (Abtastbewegung) der Abtasteinrichtung A relativ zum Teilungsträger M in Meßrichtung X erzeugen die beiden Photoelemente Pa, Pb zwei jeweils durch die Verstärker Va, Vb verstärkte periodische Abtastsignale Sa, Sb, die einen gegenseitigen Phasenwinkel von 90° wegen des gegenseitigen Versatzes der beiden Abtastteilungen ATa, ATb der Abtastplatte AP um ein Viertel ihrer Teilungsperiode aufweisen.

Die beiden periodischen Abtastsignale Sa, Sb werden einmal einer Auswerteeinrichtung W zugeführt, die zwei Meßtrigger MTa, MTb, einen Vorwärts-/Rückwärtszähler Z mit einem Richtungsdiskriminator sowie eine Anzeigeeinheit AZ aufweist. Die beiden periodischen Abtastsignale Sa, Sb werden mittels der beiden Meßtrigger MTa, MTb in zwei binäre Meßsignale MSa, MSb umgeformt und dem Vorwärts-/Rückwärtszähler Z zum vorzeichenrichtigen Zählen der Inkremente der Teilung T des Teilungsträgers M bei der Abtastung durch die Abtasteinrichtung A zugeführt. Die Zählergebnisse des Vorwärts-/Rückwärtszählers Z stellen die Meßwerte für die Relativlage der beiden zueinander verschiebbaren Objekte dar, die in der Anzeigeeinheit AZ in digitaler Form angezeigt werden.

Die beiden periodischen Abtastsignale Sa, Sb werden zum anderen einer Fehlererkennungseinrichtung F zugeführt, die zwei Triggerstufen TSa, TSb in Form von Fenstertriggern sowie eine nachgeschaltete Kontrolleinrichtung KE aufweist. Die erste Triggerstufe TSa besteht aus zwei parallelen Triggern TR1a, TR2a, deren nichtinvertierenden Eingängen das erste Abtastsignal Sa zugeführt wird und deren Ausgänge jeweils mit einem Eingang eines ersten Antivalenzgatters OGa (Exclusiv-Odergatter) verbunden sind. Die zweite Triggerstufe TSb besteht gleichfalls aus zwei parallelen Triggern TR1b, TR2b, deren nichtinvertierenden Eingängen das zweite Abtastsignal Sb zugeleitet wird und deren Ausgänge jeweils mit einem Eingang eines zweiten Antivalenzgatters OGb (Exclusiv-Odergatter) verbunden sind.

Ein Triggerschwellenformer TF weist einen ersten Spannungsteiler STa aus zwei Widerständen R1a, R2a und einen zweiten Spannungsteiler STb aus zwei Widerständen R1b, R2b auf, die jeweils mit einem Ende an Masse MP angeschlossen sind. Das andere Ende des ersten Spannungsteilers STa sind von einer positiven Versorgungsspannung +U und das andere Ende des zweiten Spannungsteilers STb von einer gleich großen negativen Versorgungsspannung –U beaufschlagt. Der erste Spannungsteiler STa liefert am Mittelabgriff MAa seiner beiden Widerstände R1a, R1b eine obere Triggerschwellenspannung TSSo, die den invertierenden Eingängen des ersten Triggers TR1a der ersten Triggerstufe TSa und des ersten Triggers TR1b der zweiten Triggerstufe TSb zugeführt wird. Der zweite Spannungsteiler STb liefert am Mittelabgriff MAb seiner beiden Widerstände R1b, R2b eine untere Triggerschwellenspannung TSSu, die den invertierenden Eingängen des zweiten Triggers TR2a der ersten Triggerstufe TSa und des zweiten Triggers TR2b der zweiten Triggerstufe TSb zugeleitet wird ; die beiden konstanten Triggerschwellenspannungen TSSo, TSSu haben somit den gleichen Betrag mit entgegengesetzter Polarität und legen die zugehörigen oberen und unteren Triggerschwellen der beiden Triggerstufen TSa, TSb fest. Die den beiden Triggerstufen TSa, TSb nachgeschaltete Kontrolleinrichtung KE besteht aus einem Undgatter UG.

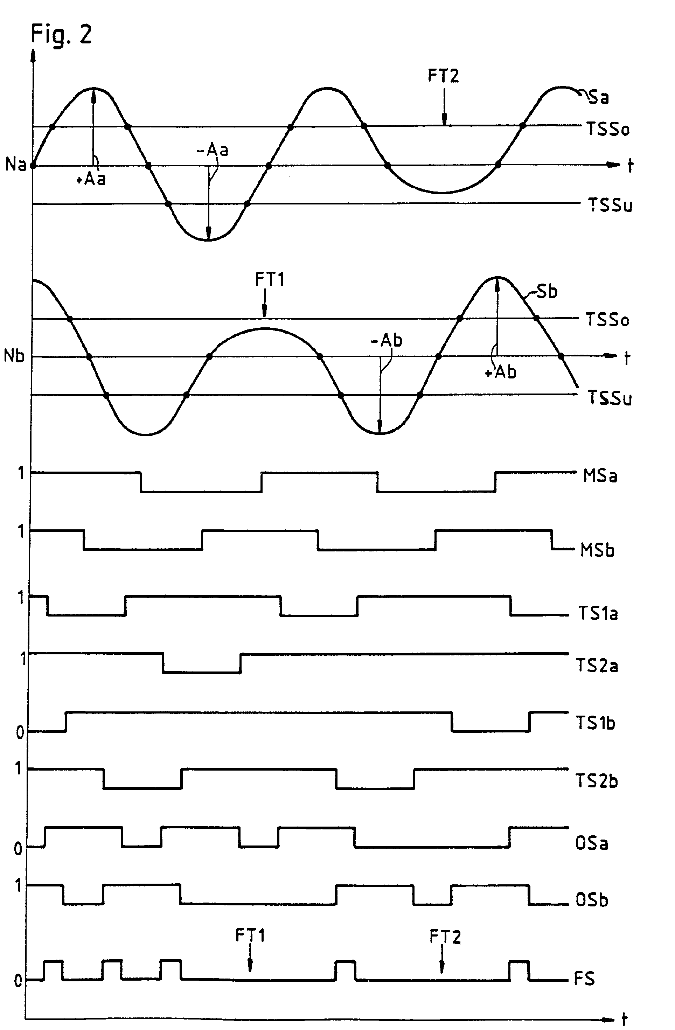

In Figur 2 sind von oben nach unten die beiden um 90° gegeneinander phasenversetzten Abtastsignale Sa, Sb mitsamt der oberen Triggerschwellenspannung TSSo und der unteren Triggerschwellenspannung TSSu als Funktion der Zeit t dargestellt. Das erste Abtastsignal Sa weisen symmetrisch zu seiner Nullinie Na die Amplitudenhöhen +Aa, –Aa und das zweite Abtastsignal Sb symmetrisch zu seiner Nullinie Nb die Amplitudenhöhen +Ab, –Ab auf. Das erste binäre Meßsignal MSa wird durch Triggerung des ersten periodischen Abtastsignals Sa in den Nulldurchgängen (Schaltpunkte) durch seine Nullinie Na mittels des ersten Meßtriggers MTa und das zweite binäre Meßsignal MSb durch Triggerung des zweiten periodischen Abtastsignals Sb in den Nulldurchgängen (Schaltpunkte) durch seine Nullinie Nb mittels des zweiten Meßtriggers MTb bei der Meßbewegung in Meßrichtung X erzeugt.

In der ersten Triggerstufe TSa werden ein erstes Triggersignal TS1a durch Triggerung des ersten Abtastsignals Sa an der oberen Triggerschwelle des ersten Triggers TR1a mittels der oberen Triggerschwellenspannung TSSo und ein zweites Triggersignal TS2a durch Triggerung des ersten Abtastsignals Sa an der unteren Triggerschwelle des zweiten Triggers TR2a mittels der unteren Triggerschwellenspannung TSSu erzeugt. Desgleichen werden in der zweiten Triggerstufe TSb ein erstes Triggersignal TS1b durch Triggerung des zweiten Abtastsignals Sb an der oberen Triggerschwelle des ersten Triggers TR1b mittels der oberen Triggerschwellenspannung TSSo und ein zweites Triggersignal TS2b durch Triggerung des zweiten Abtastsignals Sb an der unteren Triggerschwelle des zweiten Triggers TR2b mittels der unteren Triggerschwellenspannung TSSu erzeugt. Die beiden Triggersignale TS1a, TS2a der ersten Triggerstufe TSa beaufschlagen das erste Antivalenzgatter OGa und die beiden Triggersignale TS1b, TS2b der zweiten Triggerstufe TSb das zweite Antivalenzgatter OGb. Das erste Odersignal OSa am Ausgang des ersten Antivalenzgatters OGa und das zweite Odersignal OSb am Ausgang des zweiten Antivalenzgatters OGb werden dem Undgatter UG der Kontrolleinrichtung KE zugeführt, an dessen

Ausgang ein binäres Fehlererkennungssignal FS mit einem bestimmten Tastverhältnis ansteht.

Gemäß Figur 2 weisen das zweite Abtastsignal Sb an einer ersten Fehlerstelle FT1 und das erste Abtastsignal Sa an einer zweiten Fehlerstelle FT2 jeweils eine fehlerhafte Amplitudenhöhe auf. Die beiden fehlerhaften Amplitudenhöhen liegen betragsmäßig unterhalb der oberen Triggerschwellenspannung TSSo und der unteren Triggerschwellenspannung TSSu, so daß der erste Trigger TR1b der zweiten Triggerstufe TSb an der ersten Fehlerstelle FT1 und der zweite Trigger TR2a der ersten Triggerstufe TSa an der zweiten Fehlerstelle FT2 nicht ansprechen. Das konstante Tastverhältnis des Fehlererkennungssignals FS, das den fehlerfreien Zustand anzeigt, ist an den beiden Fehlerstellen FT1, FT2 unterbrochen, so daß jeweils eine Fehlermeldung ausgegeben wird. Derartige fehlerhaften Amplitudenhöhen können durch partielle Verschmutzungen oder Beschädigungen der Teilung T hervorgerufen werden und Meßungenauigkeiten zur Folge haben.

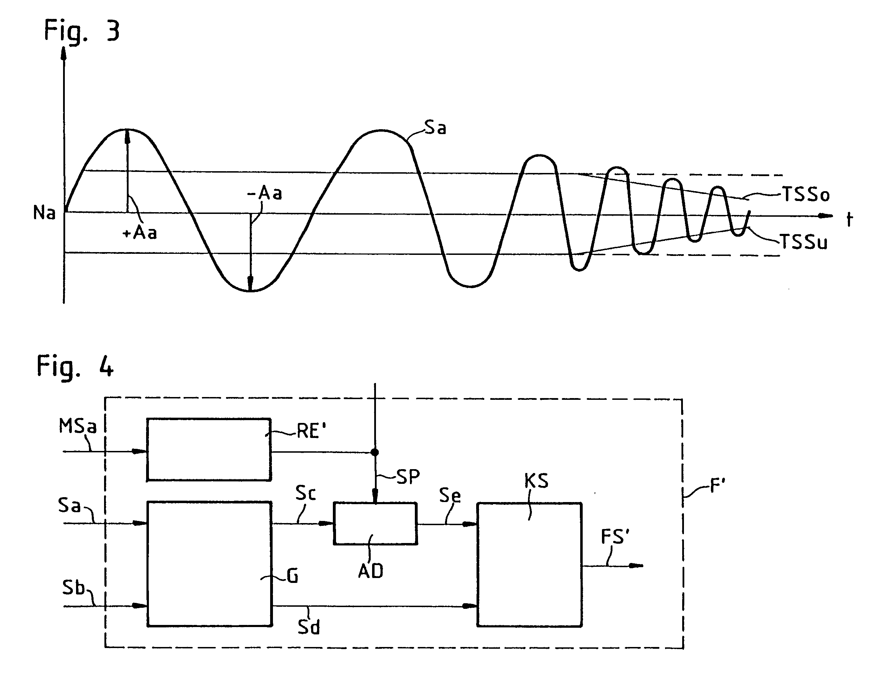

Mit zunehmender Abtastfrequenz (Abtastgeschwindigkeit) der Abtasteinrichtung A bezüglich der Teilung T des Teilungsträgers M tritt jedoch eine Abnahme der Amplitudenhöhen +Aa, −Aa, +Ab, −Ab der beiden Abtastsignale Sa, Sb ein ; in Figur 3 ist dieser frequenzabhängige Amplitudengang beim Abtastsignal Sa dargestellt. Bei hohen Abtastfrequenzen sinken die Amplitudenhöhen betragsmäßig unterhalb der fest eingestellten Triggerschwellen der beiden Triggerstufen TSa, TSb ab, so daß die Fehlererkennungseinrichtung F eine Fehlermeldung abgibt, ohne daß eine eigentliche Störung, beispielsweise eine Verschmutzung oder Beschädigung der Teilung T, vorliegt.

Zur Vermeidung derartiger Fehlermeldungen bei noch einwandfreien Abtastsignalen Sa, Sb ist in der Fehlererkennungseinrichtung F eine Regeleinrichtung RE vorgesehen, bei der eine monostabile Kippstufe MF vom binären Meßsignal MSa angesteuert wird, deren Ausgangssignal ein Schaltelement SE beaufschlagt. Die beiden Ausgänge des Schaltelements SE sind über einen Kondensator KD miteinander verbunden und gleichzeitig an die beiden Mittelabgriffe MAa, MAb der beiden Spannungsteiler TSa, TSb des Triggerschwellenformers TF angeschlossen ; zwischen einem Ausgang des Schaltelements SE und dem Kondensator KD befindet sich noch ein Einstellwiderstand R. Da diese Regeleinrichtung RE einen Nebenschluß zu den beiden Spannungsteilern TSa, TSb bildet, wird bei der Ansteuerung der monostabilen Kippstufe MF durch das binäre Meßsignal MSa bei steigender Abtastfrequenz der Stromfluß durch diesen Nebenschluß vergrößert, so daß die beiden Triggerschwellenspannungen TSSo, TSSu entsprechend verringert werden (Figur 3) ; die somit abgesenkten oberen und unteren Triggerschwellen der beiden Triggerstufen TSa, TSb liegen auch bei hohen Abtastfrequenzen unterhalb der Amplitudenhöhen der noch einwandfreien Abtastsignale Sa, Sb, so daß keine Fehlermeldung erfolgt. Mit dem Einstellwiderstand R kann die Wirksamkeit des Nebenschlusses eingestellt werden. Die Zeitkonstante $\tau$ der monostabilen Kippstufe MF ist vorzugsweise kleiner/gleich der Periodendauer der periodischen Abtastsignale Sa, Sb bei der größten zulässigen Abtastfrequenz.

In Figur 4 ist eine weitere Fehlererkennungseinrichtung F′ gezeigt, in der die beiden periodischen Abtastsignale Sa, Sb einem Gleichrichter G zugeführt werden, dessen erstes Ausgangssignal Sc jeweils das Höchste der beiden periodischen Abtastsignale Sa, Sb positiver Polarität und dessen zweites Ausgangssignal Sd jeweils das Höchste der beiden periodischen Abtastsignale Sa, Sb negativer Polarität bilden. Das erste Ausgangssignal Sc wird in einer Addierstufe AD mit einer konstanten Schwellenspannung SP überlagert und als überlagertes Signal Se mitsamt dem zweiten Ausgangssignal Sd des Gleichrichters G einer Kippstufe KS zugeleitet, die auf das Vorzeichen der Differenz des überlagerten Signals Se und des zweiten Ausgangssignals Sd anspricht und ein Fehlererkennungssignal FS′ abgibt, wenn die Differenz der beiden Signale Se, Sd einen Schwellenwert unterschreitet, der in der Addierstufe AD mittels der konstanten Schwellenspannung SP eingestellt ist. Eine derartige Fehlererkennungseinrichtung zur Erkennung fehlerhafter Amplitudenhöhen und/oder fehlerhafter Phasendifferenzen bei periodischen Abtastsignalen ist in der DE-PS 20 22 151 beschrieben.

Zur Vermeidung von Fehlermeldungen infolge des frequenzabhängigen Amplitudengangs der beiden periodischen Abtastsignale Sa, Sb ist erfindungsgemäß in der Fehlererkennungseinrichtung F′ eine Regeleinrichtung RE′ vorgesehen, die der Regeleinrichtung RE nach Figur 1 entspricht. Diese Regeleinrichtung RE′ wird vom binären Meßsignal MSa beaufschlagt und stellt einen Nebenschluß zur Regelung der Schwellenspannung SP in Abhängigkeit von der Abtastfrequenz dar.

## Ansprüche

1. Verfahren zur Fehlererkennung bei Positionsmeßsystemen zur Messung der Relativlage zweier Objekte, bei der die Teilung (T) eines Teilungsträgers (M) von einer Abtasteinrichtung (A) zur Erzeugung wenigstens eines periodischen Abtastsignals (Sa, Sb) abgetastet wird, das einmal einer Auswerteeinrichtung (W) zur Bildung von Meßwerten für die Relativlage der beiden Objekte und zum anderen einer Fehlererkennungseinrichtung (F) zur Erzeugung eines Fehlererkennungssignals (FS) bei fehlerhaften Signalparametern des wenigstens einen Abtastsignals (Sa, Sb) mittels wenigstens einer Schwellenspannung (TSSo, TSSu ; SP) zugeführt wird, dadurch gekennzeichnet, daß die wenigstens eine Schwellenspannung (TSSo, TSSu ; SP) in Abhängigkeit von der Abtastfrequenz regelbar ist.

2. Inkrementales Positionsmeßsystem zur Durchführung des Verfahrens nach Anspruch 1, bei den ein Teilungsträger (M) mit einer inkrementalen Teilung (T) vorhanden ist, die von einer Abtasteinrichtung (A) abtastbar ist, mit einer Auswenteeinrichtung (W), die sowohl Mittel (MTa, MTb) zur Umwandlung des mindestens einen periodischen Abtastsignals (Sa, Sb) in ein binäres Meßsignal (MSa, MSb), als auch Mittel (Z, AZ) zur vorzeichenrichtigen Bildung und Anzeige von Meßwerten aus diesen wenigstens einen binären Meßsignal (MSa, MSb) enthält, sowie mit einer Fehlererkennungseinrichtung (F), die bei fehlerhafter Signal parametern des wenigstens einen Abtastsignals (Sa, Sb) ein Fehlererkennungssignal (FS) mittels wenigstens einer Schwellenspannung (TSSo, TSSu ; SP) erzeugt dadurch gekennzeichnet, daß die Fehlererkennungseinrichtung (F) zwei Triggerstufen (TSa, TSb), eine nachgeschaltete Kontrolleinrichtung (KE), einen Triggerschwellenformer (TF) zur Erzeugung einer oberen Triggerschwellenspannung (TSSo) und einer unteren Triggerschwellenspannung (TSSu) für die beiden Triggerstufen (TSa, TSb) sowie eine Regeleinrichtung (RE) zur Absenkung der beiden Triggerschwellenspannungen (TSSo, TSSu) mit zunehmender Abtastfrequenz aufweist.

3. Inkrementales Positionsmeßsystem gemäß dem Oberbegriff des Anspruches 2, dadurch gekennzeichnet, daß die Fehlererkennungseinrichtung (F') einen Gleichrichter (G), eine von der Schwellenspannung (SP) beaufschlagte Addierstufe (AD), eine nachgeschaltete Kippstufe (KS) sowie eine Regeleinrichtung (RE') für die Schwellenspannung (SP) aufweist.

4. Einrichtung nach Anspruch 2, dadurch gekennzeichnet, daß die Regeleinrichtung (RE) eine monostabile Kippstufe (MF) und ein nachgeschaltetes Schaltelement (SE) aufweist, dessen Ausgänge über einen Kondensator (KD) miteinander verbunden sind.

5. Einrichtung nach Anspruch 2, dadurch gekennzeichnet, daß der Triggerschwellenformer (TF) zwei Spannungsteiler (STa, STb) aufweist, die mit den einen Enden mit Masse (MP) verbunden sind, daß der erste Spannungsteiler (STa) mit dem anderen Ende an eine positive Versorgungsspannung (+U) und der zweite Spannungsteiler (STb) mit dem anderen Ende an eine negative Versorgungsspannung (–U) angeschlossen sind und daß der Mittelabgriff (MAa) des ersten Spannungsteilers (STa) die obere Triggerschwellenspannung (TSSo) und der Mittelabgriff (MAb) des zweiten Spannungsteilers (STb) die untere Triggerschwellenspannung (TSSu) liefern.

6. Einrichtung nach den Ansprüchen 4 und 5, dadurch gekennzeichnet, daß die Ausgänge des Schaltelement (SE) der Regeleinrichtung (RE) an die Mittelabgriffe (MAa, MAb) der beiden Spannungsteiler (STa, STb) des Triggerschwellenformers (TF) angeschlossen sind und daß die monostabile Kippstufe (MF) der Regeleinrichtung (RE) von einem binären Meßsignal (MSa) beaufschlagt ist, das aus einem der beiden periodischen Abtastsignale (Sa) gewonnen ist.

7. Einrichtung nach Anspruch 4, dadurch gekennzeichnet, daß bei der Regeleinrichtung (RE) zwischen einem Ausgang des Schaltelements (SE) und dem Kondensator (KD) ein Einstellwiderstand (R) geschaltet ist.

8. Einrichtung nach Anspruch 2, dadurch gekennzeichnet, daß die Triggerstufen (TSa, TSb) jeweils aus einem ersten Trigger (TR1a, TR1b) mit einer oberen Triggerschwelle und aus einem zweiten Trigger (TR2a, TR2b) mit einer unteren Triggerschwelle bestehen und daß den beiden Triggern (TR1a, TR2a, TR1b, TR2b) jeweils ein Antivalenzgatter (OGa, OGb) nachgeschaltet ist.

9. Einrichtung nach Anspruch 2, dadurch gekennzeichnet, daß die Kontrolleinrichtung (KE) aus einem Undgatter (UG) besteht.

**Revendications**

1. Procédé de détection d'erreur dans des systèmes de mesure de position pour la mesure de la position relative de deux objets, lors de laquelle la graduation (T) d'un support de graduation (M) est explorée par un dispositif d'exploration (A) en vue de produire au moins un signal d'exploration (Sa, Sb) périodique qui est envoyé, d'une part à un dispositif d'exploitation (W), en vue de former des valeurs de mesure pour la position relative des deux objets, et d'autre part à un dispositif de détection d'erreur (F), en vue de produire un signal de détection d'erreur (FS) en cas de paramètres de signal erronés d'au moins un signal d'exploration (Sa, Sb) au moyen d'au moins une tension de seuil (TSSo, TSSu ; SP), caractérisé par le fait qu'au moins une tension de seuil (TSSo, TSSu ; SP) peut être réglée en fonction de la fréquence d'exploration.

2. Système de mesure de position incrémental pour la mise en oeuvre du procédé selon la revendication 1, comprenant un support de graduation (M) avec une graduation (T) incrémentale qui peut être explorée par un dispositif d'exploration (A), un dispositif d'exploration (W) qui contient à la fois des moyens (MTa, MTb) de conversion d'au minimum un signal d'exploration (Sa, Sb) périodique en un signal de mesure binaire (MSa, MSb) et des moyens (Z, AZ) pour la détermination correcte du signe et l'affichage de valeurs de mesure résultant d'au moins un signal de mesure (MSa, MSb) binaire, et un dispositif de détection d'erreur (F) qui, en cas de paramètres de signal erronés d'au moins un signal d'exploration (Sa, Sb), produit un signal (FS) de détection d'erreur au moyen d'au moins une tension de seuil (TSSo, TSSu; SP), caractérisé par le fait que le dispositif de détection d'erreur (F) présente deux étages de déclenchement (TSa, TSb), un dispositif de contrôle (KE) monté en aval, un dispositif de formation de seuil de déclenchement (TF) pour produire une tension de seuil de déclenchement supérieure (TSSo) et une tension de seuil de déclenchement inférieure (TSSu) pour les deux étages de déclenchement (TSa, TSb), et un dispositif de réglage (RE) pour diminuer les deux tensions de seuil de déclenchement (TSSo, TSSu) à mesure que la fréquence d'exploration augmente.

3. Système de mesure de position incrémental selon le préambule de la revendication 2, caractérisé par le fait que le dispositif de détection d'erreur (F') présente un redresseur (G), un étage additionneur (AD) commandé par la tension de seuil (SP), un étage à bascule (KS) monté en aval, et un dispositif de réglage (RE') pour la tension de seuil (SP).

4. Système selon la revendication 2, caractérisé par le fait que le dispositif de réglage (RE) présente un étage à bascule (MF) monostable et un élément de commutation (SE) monté en aval, dont les sorties sont reliées l'une à l'autre par l'intermédiaire d'un condensateur (KD).

5. Système selon la revendication 2, caractérisé par le fait que le dispositif de formation de seuil de déclenchement (TF) présente deux diviseurs de tension (STa, STb) qui sont reliés par une extrémité à la masse (MP), que le premier diviseur de tension (STa) est relié par son autre extrémité à une tension d'alimentation positive (+U) et le deuxième diviseur de tension (STb) est relié par son autre extrémité à une tension d'alimentation négative (−U) et que la prise médiane (MAa) du premier diviseur de tension (STa) fournit la tension de seuil de déclenchement supérieure (TSSo) et la prise médiane (MAb) du deuxième diviseur de tension (STb) fournit la tension de seuil de déclenchement inférieure (TSSu).

6. Système selon les revendications 4 et 5, caractérisé par le fait que les sorties de l'élément de commutation (SE) du dispositif de réglage (RE) sont connectées aux bornes médianes (MAa, MAb) des deux diviseurs de tension (STa, STb) du dispositif de formation de seuil de déclenchement (TF) et que l'étage à bascule (MF) monostable du dispositif de réglage (RE) est commandé par un signal de mesure (MSa) binaire qui est obtenu à partir de l'un des deux signaux d'exploration (Sa) périodiques.

7. Système selon la revendication 4, caractérisé par le fait que dans le dispositif de réglage (RE), un rhéostat de réglage (R) est monté entre une sortie de l'élément de commutation (SE) et le condensateur (KD).

8. Système selon la revendication 2, caractérisé par le fait que les étages de déclenchement (TSa, TSb) sont constitués chacun par un premier déclencheur (TR1a, TR1b), avec un seuil de déclenchement supérieur, et par un deuxième déclencheur (TR2a, TR2b) avec un seuil de déclenchement inférieur, et qu'une porte OU-exclusif (OGa, OGb) est montée en aval chaque fois des deux déclencheurs (TR1a, TR2a, TR1b, TR2b).

9. Système selon la revendication 2, caractérisé par le fait que le dispositif de contrôle (KE) est constitué par une porte ET (UG).

## Claims

1. Method of error detection in position measuring systems for measuring the relative position of two objects, in which the graduation (T) of a graduation carrier (M) is sensed by a sensing device (A) to generate at least one periodic sensing signal (Sa, Sb), which is fed on the one hand to a processing devices (W) for forming measured values for the relative position of the two objects and on the other hand to an error detection device (F) for generating an error detection signal (FS) by means of at least one threshold voltage (TSSo, TSSu ; SP) with erroneous signal parameters of the at least one sensing signal (Sa, Sb), characterized in that the at least one threshold voltage (TSSo, TSSu ; SP) is adjustable in dependence on the sensing frequency.

2. Incremental position measuring system for carrying out the method according to claim 1, in which there is present a graduation carrier (M) with an incremental graduation (T), which can be sensed by a sensing device (A), with a processing device (W), which comprises both means (MTa, MTb) for converting the at least one periodic sensing signal (Sa, Sb) into a binary measuring signal (MSa, MSb) and also means (Z, AZ) for correctly signed formation and display of measured values from this at least one binary measuring signal (MSa, MSb), as well as an error detection device (F), which generates an error detection signal (FS) by means of at least one threshold voltage (TSSo, TSSu, SP) with erroneous signal parameters of the at least one sensing signal (Sa, Sb), characterized in that the error detection device (F) comprises two trigger stages (TSa, TSb), a control device (KE) connected thereafter, a trigger threshold generator (TF) for generating an upper trigger threshold voltage (TSSo) and a lower trigger threshold voltage (TSSu) for the two trigger stages (TSa, TSb), as well as a regulating device (RE) for lowering the two trigger threshold voltages (TSSo, TSSu) with increasing sensing frequency.

3. Incremental position measuring system according to the pre-characterizing part of claim 2, characterized in that the error detection device (F') comprises a rectifier (G), an adder stage (AD) responsive to the threshold voltage (SP), a following switching stage (KS) as well as a regulating device (RE') for the threshold voltage (SP).

4. Device according to claim 2, characterized in that the regulating device (RE) comprises a monostable switching stage (MF) and a following circuit element (SE), whose outputs are connected together by a capacitor (KD).

5. Device according to claim 2, characterized in that the trigger threshold generator (TF) comprises two voltage dividers (STa, STb), which are connected at their one ends to earth (MS), in that the first voltage divider (STa) is connected at the other end to a positive supply voltage (+U) and the second voltage divider (STb) at the other end to a negative supply voltage (−U) and in that the middle tap (MAa) of the first voltage divider (STa) supplies the upper threshold voltage (TSSo) and the middle tap (MAb) of the second voltage divider (STb) supplies the lower threshold voltage (TSSu).

6. Device according to claims 4 and 5, characterized in that the outputs of the circuit element (SE) of the regulating device (RE) are connected to the middle taps (MAa, MAb) of the two voltage dividers (STa, STb) of the trigger threshold generator (TF) and in that the monostable switching stage (MF) of the regulating device (RE) is responsive to a binary measuring signal (MSa), which is derived from one of the two periodic sensing signals (Sa).

7. Device according to claim 4, characterized in that an adjusting resistor (R) is connected between one output of the circuit element (SE) and the capacitor (KD) in the regulating device (RE).

8. Device according to claim 2, characterized in that the trigger stages (TSa, TSb) each consist of a first trigger (TR1a, TR1b) with an upper trigger threshold and of a second trigger (TR2a, TR2b) with a lower trigger threshold and in that the two triggers (TR1a, TR2a, TR1b, TR2b) are in each case connected to a following exclusive-OR gate (OGa, OGb).

9. Device according to claim 2, characterized in that the control device (KE) consists of an AND gate (UG).

Fig. 1

EP 0 318 658 B1

Fig. 2

## Fig. 3

## Fig. 4

EP 0 318 658 B1